# EUROPEAN PATENT APPLICATION

(11) **EP 2 305 855 A1**
(43) Date of publication of application: **06.04.2011**
(21) Application number: 09773296.0
(22) Date of filing: 16.06.2009
(51) Int. Cl.: C23C 14/48, G02B 5/28

(54) **MANUFACTURING METHOD FOR VAPOR DEPOSITION DEVICE AND THIN-FILM DEVICE**

(30) Priority: 30.06.2008 JP 2008171114
(71) Applicant: Shincron Co., Ltd., Kanagawa 220-8680 (JP)
(72) Inventor: SHIONO, Ichiro, Yokohama-shi Kanagawa 220-8680 (JP); JIANG, Yousong, Yokohama-shi Kanagawa 220-8680 (JP); HONDA, Hiromitsu, Yokohama-shi Kanagawa 220-8680 (JP); MURATA, Takanori, Yokohama-shi Kanagawa 220-8680 (JP)
(74) Representative: Grünecker, Kinkeldey, Stockmair & Schwanhäusser Anwaltssozietät
(86) International application number: PCT/JP2009/060939
(87) International publication number: WO 2010/001718

(57) **Abstract**

[Object] To provide a deposition apparatus 1 capable of suppressing a temporal change in film formation conditions.

[Solution] In the deposition apparatus 1 including a substrate holder 12 supported in a vacuum chamber 10 grounded on the earth, a substrate 14 held by the substrate holder 12, deposition sources 34, 36 placed distant from the substrate 14 so as to face the substrate, an ion gun 38 for irradiating ions to the substrate 14, and a neutralizer 40 for irradiating electrons to the substrate 14, an irradiated ion guide member 50 and an irradiated electron guide member 52 are respectively attached to the ion gun 38 and the neutralizer 40.

## Description

### Technical Field

The present invention relates to a deposition apparatus of a thin film, particularly to a deposition apparatus provided with an ion gun and a neutralizer, and a manufacturing method of a thin film device manufactured using this deposition apparatus.
It should be noted that in the specification, the term electrically "floating" indicates an electrically insulated state from the other members.

### Background Art

Conventionally, there is a known deposition apparatus for performing densification by irradiating ions to deposition layers deposited on substrates at the time of evaporating thin film materials toward surfaces of the substrates in a vacuum chamber (an ion assist deposition apparatus). In such a deposition apparatus, by irradiating gas ions having relatively low energy to the substrates with an ion gun and irradiating neutral electrons (electrons) to the substrates with a neutralizer, densified films can be manufactured by motion energy of the gas ions while neutralizing a bias of an electric charge on the substrates due to the gas ions (for example, Patent Documents 1, 2).

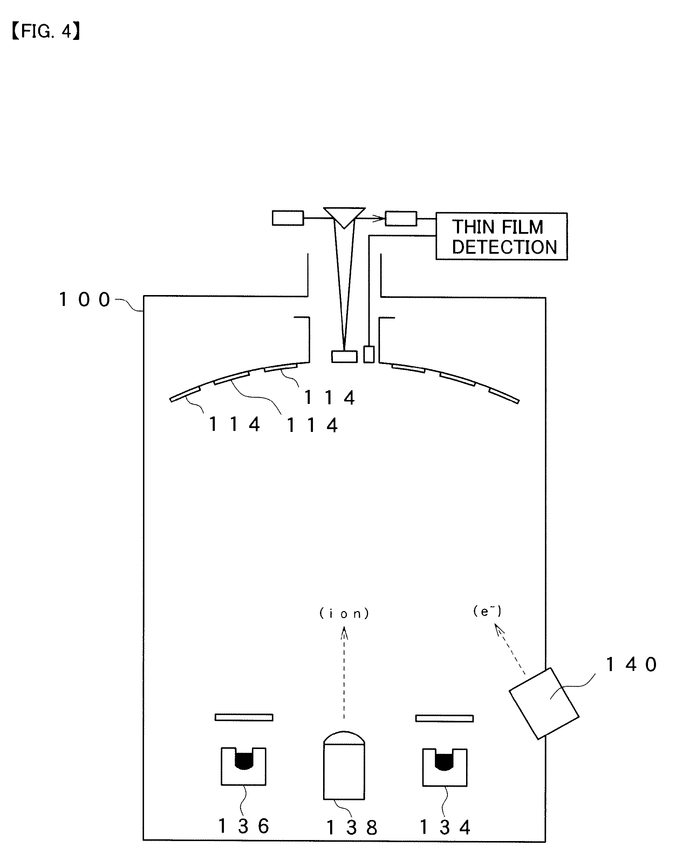

In techniques shown in Patent Documents 1, 2, as shown in Fig. 4, a high refractive material and a low refractive material are alternately evaporated and laminated from a plurality of evaporation sources 134, 136, so that antireflection layers formed by multi-layer films can be obtained. In such techniques, at the time of film formation of the high refractive material and the low refractive material respectively, evaporation materials adhered to substrates 114 are densif ied by argon ions and oxygen ions irradiated from an ion gun 138, and electrification of the substrates and the like are prevented by neutral electrons irradiated by a neutralizer 140.

Patent Document 1: Japanese Patent Application Publication No. 1998(H10)-123301
Patent Document 2: Japanese Patent Application Publication No. 2007-248828

### Disclosure of the Invention

### Problems to be Solved by the Invention

However, according to the techniques shown in Patent Document 1 or 2, when the ions are to be irradiated to all the substrates, there is an unavoidable phenomenon that part of the ions irradiated from the ion gun is collided with a wall surface of a vacuum chamber 100. Therefore, there is failure in the film formation that materials adhered to the wall surface of the vacuum chamber 100 are scattered due to the ion collisions and adhered to the substrates in the film formation as foreign substances.

Since an irradiation range of the ions irradiated from the ion gun is not easily controlled, there is a phenomenon that part of the ions irradiated from the ion gun is reacted with and neutralized by the electrons irradiated from the neutralizer before reaching the substrates. Therefore, the ions neutralized before reaching the substrates and the electrons cannot be effectually utilized, and further, extra ion currents are consumed in accordance with a neutralized amount of the ions.

In consideration with the above problems, an object of the present invention is to provide a deposition apparatus capable of controlling an irradiation range of ions irradiated from an ion gun so as to manufacture an optical filter having a high cleanliness level and high precision.
Another object of the present invention is to provide a deposition apparatus capable of highly efficiently utilizing an ion gun and a neutralizer so as to reduce manufacturing cost of an optical filter.

### Means for Solving the Problems

The above problems are solved by a deposition apparatus of claim 1, including a vacuum chamber grounded on the earth, a substrate holder supported in the vacuum chamber, a substrate capable of being held by the substrate holder, a deposition means placed distant from the substrate by a predetermined distance so as to face the substrate, an ion gun for irradiating ions to the substrate, and a neutralizer for irradiating electrons to the substrate, wherein the neutralizer is arranged so that an electron irradiation port is placed in the direction of the substrate, the ion gun is arranged on the opposite side to the side where the substrate holder is arranged inside the vacuum chamber so that an ion irradiation port faces the substrate, an irradiated ion guide member for regulating an irradiation range of the ions is arranged at a position from the ion irradiation port of the ion gun toward the substrate holder so as to reduce a diffusion range of the ions irradiated from the ion irradiation port, and the irradiated ion guide member is electrically floating.

In such a way, the deposition apparatus according to the present invention is provided with the irradiated ion guide member for regulating the irradiation range of the ions irradiated from the ion gun, and this irradiated ion guide member is electrically floating. Therefore, the side of ion passage of the irradiated ion guide member is electrified with the same electric charge as the ions in accordance with irradiation of the ions, so that the ions are guided in the direction of acting repulsively against the irradiated ion guide member. Thus, the irradiation range of the ions is regulated and a change in the irradiation range is suppressed, so that the ions collided with a wall surface inside the vacuum chamber can be reduced. In such a way, with the deposition apparatus according to the present invention, foreign substances adhered to the substrate can be reduced, so that an optical filter having a high cleanliness level and high precision can be manufactured.

In more detail, preferably, as in claim 2, an irradiated electron guide member for regulating an irradiation range of the electrons is arranged at a position from the electron irradiation port of the neutralizer toward the substrate holder so as to reduce a diffusion range of the electrons irradiated from the electron irradiation port, and the irradiated electron guide member is electrically floating.
In such a way, the deposition apparatus according to the present invention is further provided with the irradiated electron guide member for regulating the irradiation range of the electrons irradiated from the neutralizer, and this irradiated electron guide member is electrically floating. Therefore, the irradiation range of the electrons irradiated from the neutralizer can be effectually regulated. Thus, reaction and neutralization of the ions irradiated from the ion gun or the irradiated ion guide member and the electrons irradiated from the neutralizer can be suppressed, so that losses of the ions irradiated from the ion gun and the electrons irradiated from the neutralizer can be suppressed. Since the reaction of the ions irradiated from the ion gun or the irradiated ion guide member and the electrons is decreased, a bias of a potential structure in the vacuum chamber and a bias of the irradiation range of the ions can be prevented. Therefore, the ion gun and the neutralizer are highly efficiently utilized, so that manufacturing cost of the optical filter can be reduced.

Further specifically and further preferably, as in claim 3, an irradiated electron guide member for regulating an irradiation range of the electrons is arranged at a position from the electron irradiation port of the neutralizer toward the substrate holder so as to reduce a diffusion range of the electrons irradiated from the electron irradiation port, the irradiated electron guide member is electrically floating, and at least one of the irradiated ion guide member and the irradiated electron guide member is formed into a tubular shape, and arranged so that the ions irradiated from the ion gun or the electrons irradiated from the neutralizer are capable of passing through the inside of a tubular part.
In such a way, at least one of the irradiated ion guide member and the irradiated electron guide member is formed into a tubular shape, and arranged so that the irradiated ions or electrons are capable of passing through the inside of the tubular part. Thus, the ions or the electrons are precisely emitted from an opening part on one end of the irradiated ion guide member and the irradiated electron guide member toward the irradiation direction, and density of the irradiated ions or electrons can be increased. Therefore, the foreign substances adhered to the substrate can be reduced. In addition, the change in the irradiation range of the ions can be more effectively suppressed, so that a more densified optical filter can be manufactured.

Preferably, as in claim 4, the irradiated ion guide member is formed into a plate shape and arranged at a position so as to shield part of the ions irradiated from the ion gun.
In such a way, since the irradiated ion guide member is formed into a plate shape and arranged at the position so as to shield part of the ions irradiated from the ion gun, the density of the irradiated ions can be increased even with a simple structure, so that the more densified optical filter can be manufactured.

Further preferably, as in claim 5, an irradiated electron guide member for regulating an irradiation range of the electrons is arranged at a position from the electron irradiation port of the neutralizer toward the substrate holder so as to reduce a diffusion range of the electrons irradiated from the electron irradiation port, the irradiated electron guide member is electrically floating, at least one of the irradiated ion guide member and the irradiated electron guide member has a double structure including an inner member and an outer member, and the inner member and the outer member are provided side by side so as to have a gap inbetween and electrically floating from each other.
In such a way, at least one of the irradiated ion guide member and the irradiated electron guide member has the double structure including the inner member and the outer member, and the inner member and the outer member are provided side by side so as to have the gap inbetween and electrically floating from each other. Therefore, the inner member close to the ions or the electrons irradiated from the ion gun or the neutralizer is electrified, and the outer member is electrified opposite to the inner member. That is, the inner member and the outer member are electrified with the opposite electric charges, so that the irradiated ion guide member or the irradiated electron guide member can accumulate a larger electric charge. Therefore, the potential structure is not easily changed, and the irradiation range of the ions or the electrons can be more stabilized. Thus, the ion gun and the neutralizer can be highly efficiently utilized and the manufacturing cost of the optical filter can be reduced.

Specifically and preferably, as in claim 6, the vacuum chamber is provided with an inner wall electrically floating.
In such a way, the vacuum chamber according to the present invention is provided with the inner wall electrically floating. Thus, even when a state of the inner wall is temporarily changed due to adhesion of film formation materials to the inner wall of the vacuum chamber at the time of film formation, the change in the potential structure can be suppressed. Therefore, the temporal change in the potential structure, that is, the temporal change in film formation conditions can be prevented.

Preferably, as in claim 7, the neutralizer is arranged at a position distant from the ion gun.
In such a way, the neutralizer according to the present invention is arranged at the position distant from the ion gun. Therefore, the reaction and the neutralization of the ions irradiated from the ion gun and the electrons irradiated from the neutralizer before reaching the substrate can be suppressed. Thus, the losses of the ions irradiated from the ion gun and the electrons irradiated from the neutralizer can be suppressed, and the bias of the potential structure in the vacuum chamber and the bias of the irradiation range of the ions are not generated. Therefore, the temporal change in the film formation conditions can be suppressed, so that the deposition apparatus having no need for a preliminary film formation process with high productivity can be provided.

The above problems are solved by a manufacturing method of a thin film device of claim 8 by means of a deposition apparatus including a vacuum chamber grounded on the earth, a substrate holder supported in the vacuum chamber, a substrate capable of being held by the substrate holder, a deposition means placed distant from the substrate by a predetermined distance so as to face the substrate, an ion gun arranged on the opposite side to the side where the substrate holder is arranged inside the vacuum chamber so that an ion irradiation port faces the substrate, the ion gun for irradiating ions to the substrate, a neutralizer arranged on the side surface side of the vacuum chamber, the neutralizer for irradiating electrons to the substrate, shutters respectively arranged in the immediate vicinity of a deposition material irradiation port of the deposition means and the ion irradiation port of the ion gun, an irradiated ion guide member arranged at a position from the ion irradiation port of the ion gun toward the substrate holder so as to reduce a diffusion range of the ions irradiated from the ion irradiation port, and an irradiated electron guide member arranged at a position from the electron irradiation port of the neutralizer toward the substrate holder so as to reduce a diffusion range of the electrons irradiated from the electron irradiation port, the manufacturing method, including an arrangement step of arranging the substrate in the substrate holder, a setting step of rotating the substrate holder by the predetermined rotation number, setting pressure in the vacuum chamber to a predetermined value, and increasing a temperature of the substrate to a predetermined value, a preparation step of making the ion gun and the deposition means an idling state, and a deposition step of irradiating the deposition material to the substrate by opening the shutters, wherein in the deposition step, the ions are irradiated from the ion gun toward the substrate through the irradiated ion guide member, and at the same time, the electrons are irradiated from the neutralizer arranged close to the substrate holder so as to be distant from the ion gun by a predetermined distance toward the substrate through the irradiated electron guide member.
In such a way, the thin film device manufactured by the present manufacturing method with the deposition apparatus according to the present invention has an excellent characteristic even with relatively low manufacturing cost.

### Effect of the Invention

According to the deposition apparatus of claim 1, the ions can be precisely irradiated toward the irradiation direction. Thus, the foreign substances adhered to the substrate can be reduced, and the change in the irradiation range of the ions and the like can be more effectively suppressed.
According to the deposition apparatus of claim 2, the ion gun and the neutralizer are highly efficiently utilized, so that the manufacturing cost of the optical filter can be reduced.
According to the deposition apparatus of claim 3, the foreign substances adhered to the substrate can be reduced, and the change in the irradiation range of the ions can be more effectively suppressed. Therefore, the more densified optical filter can be manufactured.
According to the deposition apparatus of claim 4, the more densified optical filter can be manufactured.
According to the deposition apparatus of claim 5, the irradiation range of the ions or the electrons can be more stabilized, and the ion gun and the neutralizer are highly efficiently utilized, so that the manufacturing cost of the optical filter can be reduced.
According to the deposition apparatus of claim 6, the losses of the ions irradiated from the ion gun and the electrons irradiated from the neutralizer can be reduced, so that the temporal change in the film formation conditions can be suppressed and the manufacturing cost can be reduced.
According to the deposition apparatus of claim 7, the losses of the ions irradiated from the ion gun and the electrons irradiated from the neutralizer can be prevented, so that the cost can be reduced.
According to the manufacturing method of the thin film device of claim 8, the thin film device having an excellent characteristic can be obtained.

### Brief Description of the Drawings

[Fig. 1] A concept diagram of a deposition apparatus according to a first embodiment of the present invention.
[Fig. 2] A graph showing transmittance of optical filters of Example 1 and Comparative Example 1.
[Fig. 3] A concept diagram of a deposition apparatus according to a second embodiment of the present invention.
[Fig. 4] A concept diagram of a conventional deposition apparatus.

### Explanation of Reference Characters

1, 2: Deposition apparatus
10, 100: Vacuum chamber
12: Substrate holder
14, 114: Substrate
18: Crystal monitor
19: Film thickness detection portion
30: Inner wall
34, 36, 134, 136: Evaporation source
34a, 36a, 38a: Shutter
38, 138: Ion gun
40, 140: Neutralizer
50: Irradiated ion guide member
52: Irradiated electron guide member
T: Transmittance
λ: Wavelength

### Best Modes for Carrying out the Invention

Hereinafter, one embodiment of the present invention will be described with reference to the drawings. It should be noted that members, arrangement and the like described below are only one example embodying the invention, and the present invention is not limited thereto. As a matter of course, the members, the arrangement and the like can be variously modified along the gist of the present invention.

### (First Embodiment)

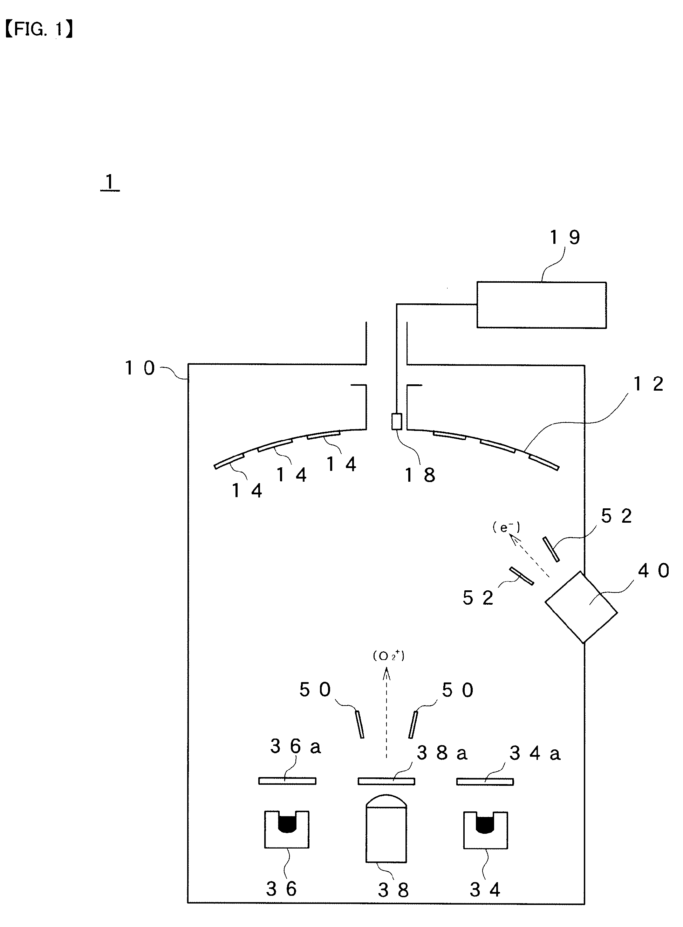

A configuration of a deposition apparatus 1 according to the first embodiment of the present invention will be described with Fig. 1.
Fig. 1 is the concept diagram of the deposition apparatus 1 according to the first embodiment.
The deposition apparatus 1 according to the present embodiment mainly includes a vacuum chamber 10, a substrate holder 12, evaporation sources 34, 36, an ion gun 38, a neutralizer 40, an irradiated ion guide member 50, and an irradiated electron guide member 52.

The vacuum chamber 10 according to the present embodiment is a stainless container normally used in a known film formation device, which is a cylindrical member to be vertically mounted and grounded on the earth so as to have ground potential.
It should be noted that the inside of this vacuum chamber 10 is exhausted so that pressure thereof becomes predetermined pressure (such as about 3 × 10⁻² to 10⁻⁴ Pa) by an exhaust means (not shown).

The substrate holder 12 according to the present embodiment is a stainless member formed into a dome shape (a substantially semi-spherical shape), which is held on the upper side in the vacuum chamber 10 rotatably around a vertical axis.
This substrate holder 12 is coaxially connected to an output shaft of a motor (not shown).
A large number of substrates 14 are fixed to a lower surface of the substrate holder 12 so that film formation surfaces thereof are directed downward.

Further, the substrate holder 12 is supported on the output shaft of the motor (not shown) (fixed on the outer side of the vacuum chamber 10) via an insulating material (not shown) such as an insulator, and electrically floating.
A film thickness detection device is arranged in a hole portion provided in a center of the substrate holder 12. In the present embodiment, a known crystal monitor 18 is provided as the film thickness detection device. The crystal monitor 18 detects physical film thickness from a change in a resonance frequency due to adhesion of a thin film on a surface thereof with a film thickness detection portion 19. As a matter of course, the crystal monitor 18 and a known optical monitor may be both provided as the film thickness detection device, so that the film thickness is measured.

The substrates 14 installed in this substrate holder 14 are made of a material having light transmittance, and dielectric films or absorption films are adhered to surfaces thereof by deposition. Although the disc shaped substrates 14 are used in the present embodiment, a shape of the substrates is not limited to this. The substrates may be formed into the other shapes such as a lens shape, a cylindrical shape and an annular shape as long as thin films can be formed on the surfaces.

The evaporation sources 34, 36 according to the present embodiment are devices for heating and evaporating a high refractive material and a low refractive material by an electronic beam heating method, which are arranged on the lower side in the vacuum chamber 10.
In the present embodiment, the evaporation source 34 is formed as an evaporation means of the high refractive material, and the evaporation source 36 is formed as an evaporation means of the low refractive material.
On the upper side of the evaporation sources 34, 36 and the ion gun 38 described below, openable and closable shutters 34a, 36a, 38a are attached. These shutters 34a, 36a, 38a are appropriately controlled to open and close by a controller (not shown).

It should be noted that although the film formation is performed by alternately laminating the high refractive material and the low refractive material for an optical filter in which the film formation is performed in the present embodiment, the present invention is applicable to the film formation of the optical filter including one kind or plural kinds of evaporation materials. In that case, the number and arrangement of the evaporation source can be appropriately changed.
Further, as a specific example of the optical filter manufactured in the present embodiment, a short wave pass filter (SWPF) is provided. However, in addition to this, the present invention is applicable to a thin film device such as a long wave pass filter, bandpass filter and a ND filter.

The ion gun 38 according to the present embodiment is a device for emitting ions (ion) toward the substrates 14, which takes out electrified ions (O₂⁺, Ar⁺) from a plasma of a reactive gas (such as O₂) and a rare gas (such as Ar), accelerates the ions with an accelerating voltage, and injects the ions.

The neutralizer 40 according to the present embodiment is to emit electrons (e⁻) toward the substrates 14, for taking out the electrons from the plasma of the rare gas such as Ar, accelerating the electrons with the accelerating voltage, and injecting the electrons. The electrons emitted from the neutralizer neutralize the ions adhered to the surfaces of the substrates 14.
In the deposition apparatus 1 according to the present embodiment, the neutralizer 40 is arranged on the side surface side of the vacuum chamber 10 and positioned so as to be distant from the ion gun 38 by a predetermined distance.
In comparison to a conventional apparatus of this type, the neutralizer 40 according to the present embodiment is arranged at a position distant from the ion gun 38 by a predetermined distance and close to the substrate holder 12.

The irradiated ion guide member 50 according to the present embodiment is a stainless member formed into a substantially tubular shape, more specifically a trumpet shape, which is arranged in the vicinity of an ion injection port of the ion gun 38 and formed so that opening width of an end on the side apart from the ion gun 38 is larger. The irradiated ion guide member 50 is attached on the lower surface side of the vacuum chamber 10 via an attachment jig and an insulator and electrically floating. The irradiated ion guide member is arranged so that the ions irradiated from the ion gun 38 pass through a tubular part of the irradiated ion guide member 50.

The irradiated electron guide member 52 according to the present embodiment is a stainless member formed into a substantially tubular shape, which is arranged in the vicinity of an electron injection port of the neutralizer 40 and formed so as to have a similar shape to the irradiated ion guide member 50 described above. The irradiated electron guide member is arranged so that the electrons irradiated from the neutralizer 40 pass through a tubular part of the irradiated electron guide member 52. The irradiated electron guide member is attached to the vacuum chamber 10 via an attachment jig and an insulator and electrically floating.

Effects of the irradiated ion guide member 50 will be described.
When the ions are irradiated from the ion gun 38 and pass through the inside of the irradiated ion guide member 50, the inside is electrified in accordance with the electric charge of the ions. In the present embodiment, since O₂⁺ is used as the ions, the inside of the irradiated ion guide member 50 is positively electrified.
Therefore, O₂⁺ irradiated from the ion gun 38 is reacted with the inner surface of the irradiated ion guide member 50 which is positively electrified and guided in the opening direction of the irradiated ion guide member 50.
In such a way, the ions emitted in the desired direction are increased, whereas the ions undesirably collided with the wall surface of the vacuum chamber 10 such as a surface of the inner wall are reduced. Therefore, scatter of adhesion articles adhered to the wall surface due to the ion collisions and adhesion of the adhesion articles to the substrates 14 as foreign substances can be suppressed.

The irradiated ion guide member 50 has an effect of increasing density of the ions irradiated form the ion gun 38.
This is because the ions reflect the members electrified by the floating process so as to be guided to an opening part of the irradiated ion guide member 50. That is, with the deposition apparatus of which a conventional irradiated ion guide member 50 is replaced, ions can be emitted in the desired direction and accordingly the density of the irradiated ions can be increased, instead of irradiation and scattering of ions in the peripheral directions.

In such a way, since the density of the ions irradiated through the irradiated ion guide member 50 is increased, the deposition materials adhered to the substrates 14 can be efficiently densified.
Therefore, an optical filter manufactured by the deposition apparatus 1 provided with the irradiated ion guide member 50 is densified and an optical characteristic thereof is improved. Specifically, an absorption rate of a visible ray incident on the optical filter is lowered, so that the optical filter with improved transmittance and high precision can be manufactured.
As a matter of course, a processing time can be shortened. In this case, productivity can be improved and cost can be reduced.

Next, effects of the irradiated electron guide member 52 will be described.
When the electrons irradiated from the neutralizer 40 pass through the inside of the tubular irradiated electron guide member 52, the inside is negatively electrified. Therefore, the electrons irradiated from the neutralizer 40 act repulsively against an inner surface of the irradiated electron guide member 52 which is negatively electrified as well as the electrons so as to be guided in the opening direction of the irradiated electron guide member 52.
In such a way, the electrons emitted in the desired direction are increased, whereas the electrons scattered away from the irradiation direction are reduced. Thus, consumption of the electrons for neutralization of the ions irradiated from the ion gun 38 toward the substrates 14, and consumption of the electrons for neutralization of the electric charge of the irradiated ion guide member 50 can be suppressed. That is, by providing the irradiated electron guide member 52, the ion gun 38 and the irradiated ion guide member 50 can be more efficiently used.

Since the deposition apparatus 1 described above is provided with the irradiated ion guide member 50 and the irradiated electron guide member 52, the deposition materials adhered to the substrates 14 are densified, so that the optical filter with high transmittance can be manufactured, and the scatter of the foreign substances from the wall surface of the chamber due to the irradiation of the ions is prevented, so that failure in the film formation can be reduced. By providing the irradiated electron guide member 52, unnecessary neutralization of the ions irradiated from the ion gun 38 toward the substrates 14 and the electric charge of the irradiated ion guide member 50 can be prevented, so that the ion gun 38 and the irradiated ion guide member 50 can be more efficiently used.

Hereinafter, operation of the deposition apparatus 1 according to the present embodiment will be described. Firstly, the substrates 14 are set in the substrate holder 12 in the vacuum chamber 10, and the inside of the vacuum chamber 10 is exhausted so as to have predetermined pressure.
The substrate holder 12 is rotated by the predetermined rotation number, and a temperature of the substrates 14 is increased to a predetermined temperature by an electric heater (not shown).
Next, an ion source of the ion gun 38 is made to be an idling state capable of immediately irradiating the ions. At the same time, the evaporation sources 34, 36 are made to be a state capable of immediately emitting evaporation particles (that is, by opening the shutters 34a, 36a, the evaporation particles get ready for being immediately emitted).
After confirming that the rotation number of the substrate holder 12 and the temperature of the substrates 14 reach predetermined conditions by performing such operation, an evaporation step is executed.

In the evaporation step, opening and closing of the shutters of the evaporation source 34 for emitting the high refractive material (such as Ta₂O₅ and TiO₂) and the evaporation source 36 for emitting the low refractive material (such as SiO₂) are controlled, so that the high refractive material and the low refractive material are alternately emitted toward the substrates 14. While emitting these deposition materials, the shutter 38a of the ion gun 38 is opened and the emitted ions (such as O₂⁺) are collided with the substrates 14, so that the deposition materials adhered to the substrates 14 are densified. By repeating this operation for predetermined times, multi-layer films are formed.

In general, a bias of an electric charge is generated in the substrate holder 12 due to the irradiation of the ions. However, in the deposition apparatus 1, the bias of the electric charge of this substrate holder 12 is neutralized by irradiating the electrons from the neutralizer 40 toward the substrate holder 12.
At this time, by the effects of the irradiated ion guide member 50 and the irradiated electron guide member 52, the ions emitted from the ion gun 38 and the electrons emitted from the neutralizer 40 can be precisely irradiated toward the substrate holder 12.
Therefore, the ions and the electrons which are conventionally collided with the wall surface of the vacuum chamber 10 and lost can be reliably irradiated to the substrates 14 and effectually utilized. As a result, the scatter of the foreign substances from the wall surface of the chamber due to the irradiation of the ions is prevented, so that the failure in the film formation can be reduced. Further, when the same power as film formation conditions in the conventional apparatus is applied to the ion gun 38 and the film formation is performed, higher ion current density can be achieved on the substrates 14, so that the film formation can be performed for a shorter time than the conventional apparatus.
Even with lower power than the conventional film formation conditions, the similar ion current density to the conventional apparatus can be achieved on the substrates 14, so that films with lower stress than the conventional apparatus can be manufactured.

By arranging the neutralizer 40 at the position close to the substrate holder 12, the electrons can be precisely irradiated toward an area of the substrate holder 12 where the ions irradiated from the ion gun 38 are adhered.
Further, since the neutralizer 40 is arranged at the position distant from the ion gun 38, the ions moving from the ion gun 38 toward the substrates 14 and the electrons emitted from the neutralizer 40 are not often directly reacted with each other. Thus, the electric charge of the substrate holder 12 can be efficiently neutralized.

In the first embodiment described above, the irradiated ion guide member 50 is formed into a substantially tubular shape. However, the irradiated ion guide member may be formed into the other shapes, a hollow square columnar shape or a ring shape. The irradiated ion guide member may be formed as a plate shape (shutter shape) member (a shielding member) for partly shielding an upper part of the ion gun 38.
For example, when the irradiation port of the ion gun 38 is shielded by a predetermined rate with a plate shaped shielding member electrically floating, the ions cannot be collided with the shielding member electrified by the floating process but emitted from an unshielded opening part. Therefore, as well as the irradiated ion guide member 50 of the second embodiment, the density of the ions irradiated from the ion gun 38 can be improved. That is, by colliding the ions emitted from the irradiation port of the ion gun 38 which is partly shielded by the floating shielding member with the substrates 14, the deposition materials adhered to the substrates 14 can be efficiently densified. It should be noted that the rate of shielding the irradiation port of the ion gun 38 can be 10 to 70%, preferably about 30%.

In the deposition apparatus 1 described above, it is more effective that the irradiated ion guide member 50 and the irradiated electron guide member 52 are formed so as to have double stainless structures.
For example, the irradiated ion guide member 50 includes an inner member attached on the inner side and an outer member attached on the outer side so as to cover this inner member. The inner member and the outer member are provided side by side so as to have a slight gap inbetween and electrically floating from each other. At this time, the inner member and the outer member may be floating by attaching via an insulating member such as an insulator.
When the irradiated ion guide member 50 is formed in such a way, the inner member and the outer member have a characteristic as a capacitor. That is, the inner member close to the ions irradiated from the ion gun 38 is electrified with the electric charge of the ions, and the outer member is electrified opposite to the inner member. In such a way, the inner member and the outer member are electrified with the opposite electric charges, so that the irradiated ion guide member 50 can accumulate a large electric charge. Therefore, even when the electrons are irradiated, a potential structure is not easily changed, and the irradiation range of the ions can be more stabilized.
As a matter of course, by making the irradiated electron guide member 52 have the similar structure, a potential structure of the irradiated electron guide member 52 can also be more stabilized.

Example 1 in which the film formation is performed using the deposition apparatus 1 shown in Fig. 1 will be described in comparison to Comparative Examples 1 and 2 in which the film formation is performed with the conventional deposition apparatus (refer to Fig. 4).
The conventional apparatus is an apparatus in which the irradiated ion guide member 50 and the irradiated electron guide member 52 of the deposition apparatus 1 according to the present embodiment are not provided, and a neutralizer 140 is arranged in the vicinity of an ion gun 138 (refer to Fig. 4).
In multi-layer films manufactured in Example 1 and Comparative Examples 1 and 2, Ta₂O₅ is used as the high refractive material and SiO₂ is used as the low refractive material. In all Example 1 and Comparative Examples 1 and 2, the multi-layer films of a short wave pass filter (SWPF) including 37 layers (total film thickness: 3,300 nm) are deposited in a first batch after chamber maintenance.

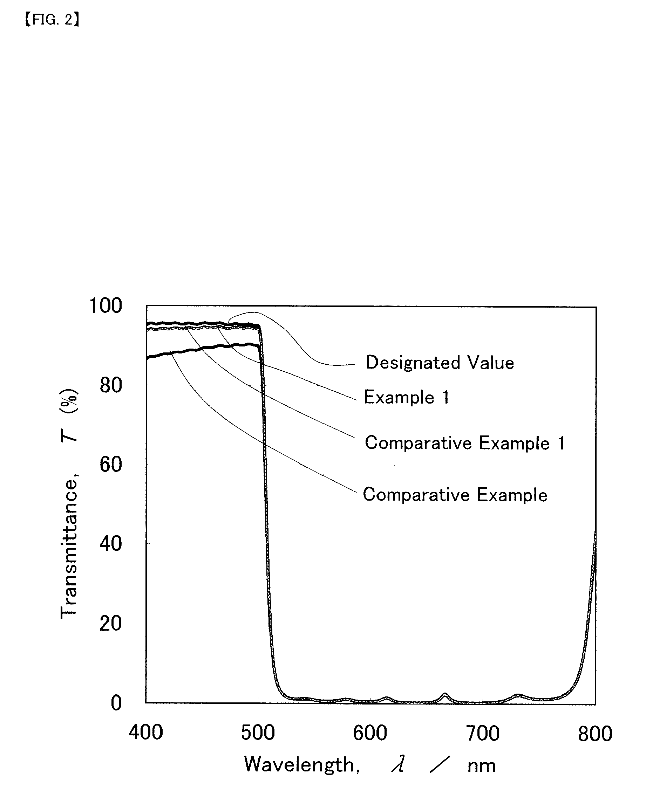

Fig. 2 shows measurement results of optical characteristics of the manufactured SWPF multi-layer films. The density of the foreign substances adhered onto the substrates 14 in the film formation is compared.

### (Example 1)

Firstly, Example 1 will be described.
Substrate: BK7 (refractive index n = 1.52)
Temperature of substrate: 150°C
Film material: Ta₂O₅ (high refractive film), SiO₂ (low refractive film)
Deposition speed of Ta₂O₅: 0.7 nm/sec
Deposition speed of SiO₂: 1.0 nm/sec
Ion gun conditions upon evaporation of Ta₂O₅
   Introduced gas: 60 sccm of oxygen
   Accelerating voltage of ion: 1,000 V
   Ion current: 1,000 mA
Ion gun conditions upon evaporation of SiO₂
   Introduced gas: 60 sccm of oxygen
   Accelerating voltage of ion: 1,000 V
   Ion current: 1,000 mA
Neutralizer conditions
   Accelerating voltage: 30 V
   Neutralizer current: 2,000 mA
   Discharge gas: 10 sccm of argon

Microscopic observation was performed regarding the foreign substances adhered to the SWPF multi-layer films manufactured in Example 1 described above.
The microscopic observation was performed regarding the substrates 14 attached on the outer peripheral side of the substrate holder 12. This is because the foreign substances scattered due to the irradiated ions are easily adhered to an area from the wall surface to the outer peripheral side of the substrate holder 12. As a result of the microscopic observation, the foreign substances were adhered to the SWPF multi-layer films manufactured in Example 1 with the density of 2 piece / cm².

### (Comparative Example 1)

Film formation conditions of Comparative Example 1 are as follows. In comparison to Example 1, values of the ion current are different.
It should be noted that the foreign substances were adhered to the SWPF multi-layer films manufactured in Comparative Example 1 with the density of 15 piece / cm².
Substrate: BK7 (refractive index n = 1.52)
Temperature of substrate: 150°C
Film material: Ta₂O₅ (high refractive film), SiO₂ (low refractive film)
Deposition speed of Ta₂O₅: 0.7 nm/sec
Deposition speed of SiO₂: 1.0 nm/sec
Ion gun conditions upon evaporation of Ta₂O₅
   Introduced gas: 60 sccm of oxygen
   Accelerating voltage of ion: 1,000 V
   Ion current: 1,200 mA
Ion gun conditions upon evaporation of SiO₂
   Introduced gas: 60 sccm of oxygen
   Accelerating voltage of ion: 1,000 V
   Ion current: 1,200 mA
Neutralizer conditions
   Accelerating voltage: 30 V
   Neutralizer current: 2,000 mA
   Discharge gas: 10 sccm of argon

### (Comparative Example 2)

Film formation conditions of Comparative Example 2 are as follows. The film formation was performed using the conventional apparatus under the same conditions as Example 1. In comparison to Comparative Example 1, the values of the ion current are different.
It should be noted that the foreign substances were adhered to the SWPF multi-layer films manufactured in Comparative Example 1 with the density of 13 piece / cm². Substrate: BK7 (refractive index n = 1.52)
Temperature of substrate: 150°C
Film material: Ta₂O₅ (high refractive film), SiO₂ (low refractive film)
Deposition speed of Ta₂O₅: 0.7 nm/sec
Deposition speed of SiO₂: 1.0 nm/sec
Ion gun conditions upon evaporation of Ta₂O₅
   Introduced gas: 60 sccm of oxygen
   Accelerating voltage of ion: 1,000 V
   Ion current: 1,000 mA
Ion gun conditions upon evaporation of SiO₂
   Introduced gas: 60 sccm of oxygen
   Accelerating voltage of ion: 1,000 V
   Ion current: 1,000 mA
Neutralizer conditions
   Accelerating voltage: 30 V
   Neutralizer current: 2,000 mA
   Discharge gas: 10 sccm of argon

Table 1 shows ion irradiation conditions of the SWPF multi-layer films manufactured in Example 1 and Comparative Examples 1 and 2 described above and the density of the foreign substances on the substrates. It should be noted that Table 1 only shows the ion currents which are different conditions between Example 1 and Comparative Examples 1 and 2 among the ion irradiation conditions.

**[Table 1]**

| | Irradiated ion/electron guide member | Ion current | Foreign substance on substrate |
|---|---|---|---|
| Example 1 | provided | 1,000 mA | 2 piece / cm² |
| Comparative Ex. 1 | not provided | 1,200 mA | 15 piece / cm² |
| Comparative Ex. 2 | not provided | 1,000 mA | 13 piece / cm² |

Firstly, the optical characteristics are compared based on Fig. 2.
In Fig. 2, a wavelength λ in a visible light region from 400 to 800 nm is irradiated to the manufactured SWPF multi-layer films, and transmittance T thereof is plotted in the graph relative to the wavelength λ.
According to Fig. 2, the multi-layer films manufactured in Example 1 and the multi-layer films in Comparative Example 1 have substantially similar transmittance T to a designed value over the entire range of the wavelength λ (400 to 800 nm) with which the transmittance T is measured.
Meanwhile, the SWPF multi-layer films manufactured in Comparative Example 2 have a lower value of the transmittance T than the multi-layer films in Example 1 within a range of the wavelength λ from 400 to 500 nm.

Specifically, with the transmittance T of the wavelength λ = 400 nm, comparing to the designed value of 95.1%, the transmittance T of the SWPF multi-layer films in Example 1 is 93.5%, the transmittance T of the SWPF multi-layer films in Comparative Example 1 is 93.6%, and the transmittance T of the SWPF multi-layer films in Comparative Example 2 is 86.6%.
With the transmittance T of the wavelength λ = 500 nm, comparing to the designed value of 94.8%, the transmittance T of the SWPF multi-layer films in Example 1 is 93.9%, the transmittance T of the SWPF multi-layer films in Comparative Example 1 is 94.0%, and the transmittance T of the SWPF multi-layer films in Comparative Example 2 is 89.6%.
Within a range of the wavelength λ from 520 to 780 nm, the transmittance is almost zero in all Example 1 and Comparative Examples 1 and 2.

Even through the values of the ion current are set to be lower than the SWPF multi-layer films of Comparative Example 1, the SWPF multi-layer films of Example 1 have a favorable optical characteristic regarding the transmittance T. This is thought to be because a decrease in the density of the irradiated ions is suppressed by the effect of the irradiated ion guide member 50. The transmittance T of the SWPF multi-layer films of Example 1 and Comparative Example 1 have substantially similar optical characteristics. That is, the values of the ion current in Comparative Example 1 are 1,200 mA, whereas the values of the ion current in Example 1 are 1,000 mA. Thus, by providing the irradiated ion guide member 50 and the irradiated electron guide member 52, it is thought that the values of the ion current can be reduced by 15 to 20%.
Meanwhile, in Comparative Example 2 in which the values of the ion current are set to be lower than Comparative Example 1, it is found that the transmittance T is decreased. This is thought to be because since the values of the ion current are set to be low, the density of the irradiated ions is lowered, so that an effect of densifying the deposition materials laminated on the substrates 14 is reduced.

Next, the density of the foreign substances adhered onto the deposited SWPF multi-layer films (the substrates 14) is compared. The density is 2 piece / cm² in Example 1, whereas the density is 15 piece / cm² in Comparative Example 1 and the density is 13 piece / cm² in Comparative Example 2.
In Comparative Example 1, a large number of the foreign substances were confirmed on the substrates 14. This is because the ions irradiated from the ion gun 38 are irradiated to the wall surface of the vacuum chamber 10.
In Comparative Example 2, since the values of the ion current are set to be lower than Comparative Example 1, the number of the foreign substances adhered onto the substrates 14 is slightly reduced but a still large number of the foreign substances were confirmed. This is because the irradiation range of the ions irradiated from the ion gun 38 is unchanged from Comparative Example 1.
Comparing to Comparative Examples 1 and 2, in Example 1, the foreign substances confirmed on the substrates 14 are remarkably reduced. This is because the irradiation range of the irradiated ions is regulated by the effect of the irradiated ion guide member 50, so that the ions irradiated to the wall surface of the vacuum chamber 10 are reduced.

### (Second Embodiment)

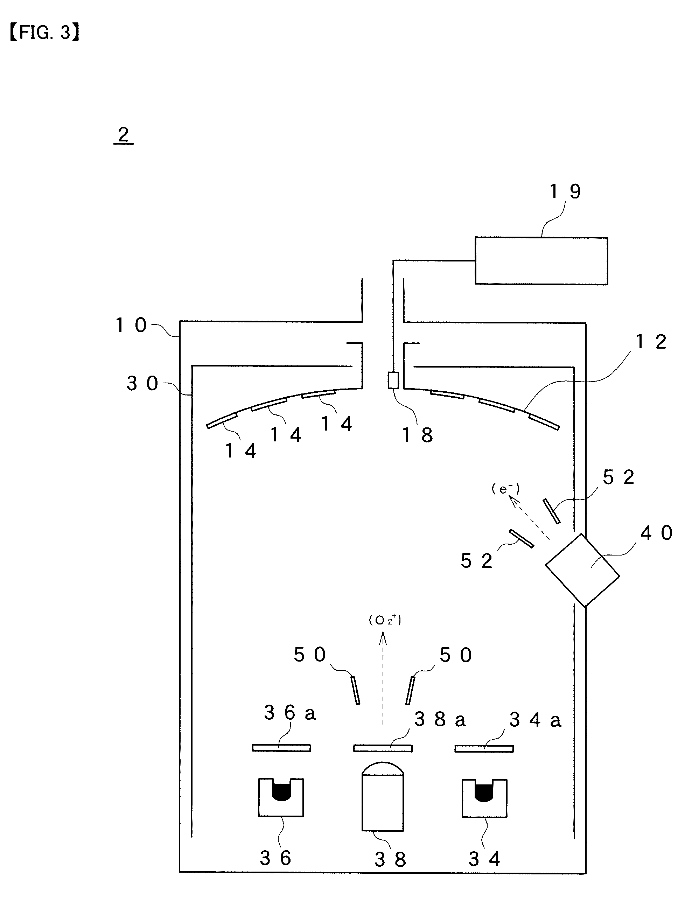

Fig. 3 is a concept diagram of a deposition apparatus 2 according to a second embodiment of the present invention.
It should be noted that in the following embodiment, the same members, arrangement and the like as the first embodiment will be given the same reference characters, and detailed description thereof will be omitted.
In the deposition apparatus 2 according to the present embodiment, an inner wall 30 is attached on the inner side of the vacuum chamber 10 of the deposition apparatus 1 according to the first embodiment. In the deposition apparatus 2, the neutralizer 40 is arranged on the inner side of an opening part provided in the inner wall 30 and directly attached to the side surface of the vacuum chamber 10 without direct contact with the inner wall 30.

The inner wall 30 provided on the inner side of this vacuum chamber 10 is a substantially cylindrical member arranged along the side surface and an upper surface on the inner side of the vacuum chamber 10, which is electrically floating. The inner wall 30 is arranged so as to surround the upper side and a side surface in the circumferential direction of the substrate holder 12 described below.
This inner wall 30 is fixed to an inner surface of the vacuum chamber 10 having the ground potential via an insulating member (not shown) such as an insulator. In such a way, by insulating the inner wall from the vacuum chamber 10, a floating process of the inner wall 30 is performed.
It should be noted that the inner wall 30 is made of a stainless member as well as the vacuum chamber 10, and a ceramic sheet (not shown) having a coating of ceramic such as silica is adhered to an inner surface thereof.

Due to the inner wall 30 electrically floating from the vacuum chamber 10, a phenomenon that the film formation conditions are temporarily changed is solved. Particularly, there is an effect of preventing the temporal change in the film formation conditions after performing chamber maintenance such as cleaning of the inside of the vacuum chamber 10.
Since the inner wall 30 is arranged so as to surround the upper side and the side surface side of the substrate holder 12, the change in the potential structure can be prevented over the entire surfaces on the inner side.

It should be noted that by adhering the ceramic sheet on the inner side of the inner wall 30, an effect of increasing an insulating property of the inner wall 30 and further reducing the change in the potential state in the inner wall 30 and the vacuum chamber 10 to which the deposition materials having an insulating property are partly adhered can be expected.
However, the ceramic sheet is not necessarily used. Also in this case, since the inner wall 30 is processed so as to be electrically floating, the change in the potential structure due to the adhesion of the deposition materials to the inner wall 30 can be suppressed within a small range.

An impact of the floating of the inner wall 30 on a film formation step will be examined.
In the conventional deposition apparatus (refer to Fig. 4), when the insulating deposition materials adhered to an inner surface of a vacuum chamber 100 (a chamber inner wall) are removed by maintenance of the deposition apparatus (chamber maintenance), the chamber inner wall is conducted to a chamber main body so as to have the ground potential after the chamber maintenance.
Therefore, in film formation after the maintenance, the electrons are absorbed by the chamber inner wall.
Meanwhile, in order to completely oxidize dielectric films such as a high refractive film and a low refractive film, there is a need for sufficiently supplying not only the oxygen ions (O₂⁺) but also the electrons (e⁻). When the chamber inner wall is conducted to the chamber main body, the dielectric films on the substrates cannot receive sufficient electrons so as not to be completely oxidized.
Since the insulating evaporation materials are adhered to the chamber inner wall by performing the film formation, the potential structure in the vacuum chamber is gradually changed.

As in the deposition apparatus 2 according to the present embodiment (refer to Fig. 2), by doubling the inner side of the vacuum chamber 10 and floating the inner wall 30, the inner wall 30 is not conducted to the vacuum chamber 10 even after the chamber maintenance. Therefore, gradual change of the potential structure in the vacuum chamber 10 is prevented, so that stable film formation can be performed immediately after the chamber maintenance.
Therefore, there is no need for performing test batch (film formation performed until the potential state of the chamber inner wall is stabilized after performing the chamber maintenance) which is conventionally performed in film formation by an ion assist deposition method.

When an optical characteristic of an optical filter manufactured by the deposition apparatus 2 described above is measured, the transmittance T is improved in comparison to an optical filter manufactured by the deposition apparatus without inner wall 30 electrically floating.
It is examined that the improvement of the transmittance T due to the floating of the inner wall 30 for the electric insulation is based on the following reasons.
The floating of the inner wall 30 arranged in the vacuum chamber 10 reduces an amount of the electrons absorbed from the inner wall 30 after the maintenance. Therefore, sufficient electrons are supplied to the surfaces of the substrates 14, so that the dielectric films such as the high refractive film and the low refractive film can be completely oxidized. Thus, uniformity of the deposited structures is improved. In such a way, since the film structures have favorable uniformity, stable films with a reduced change in the refractive index and not more than a fixed value of a light absorption coefficient can be obtained.

Conventionally, the crystal monitor 18 and a known optical monitor are both provided as the film thickness detection device, so that the film thickness is measured. However, with the deposition apparatus 1 according to the present embodiment, the potential structure in the vacuum chamber 10 is not changed even after the chamber maintenance, so that the temporal change in the film formation conditions, particularly the change in the irradiation range of the ions irradiated from the ion gun 38 is not generated. Thus, film formation speed is stabilized, and film thickness measurement with high precision can be performed even by film thickness measurement only with the crystal monitor 18.

It should be noted that even when the substrate holder 12 is not electrically floating, the optical characteristic of the SWPF multi-layer films deposited in the first batch after the chamber maintenance has the substantially same result as the SWPF multi-layer films manufactured by the apparatus in which the substrate holder 12 is electrically floating.
This is thought to be because the floating of the inner wall 30 has a greater impact on the film conditions than the floating of the substrate holder 12.

As a matter of course, since the irradiated ion guide member 50 and the irradiated electron guide member 52 are provided as well as the deposition apparatus 1, the deposition apparatus 2 also has the effects of the deposition apparatus 1 according to the first embodiment.

In the embodiment described above, the inner wall 30 is formed into a substantially cylindrical shape surrounding the circumference of the substrate holder 12. However, the inner wall may be formed into the other shapes as long as covering a range where the ions irradiated from the ion gun 38 are collided. For example, the inner wall can be formed as a plurality of plate shaped members arranged in the circumference of the substrate holder 12.
The inner wall 30 and the irradiated ion guide member 50 or the irradiated electron guide member 52 are made of stainless but may be made of the other materials such as an aluminum alloy and ceramic.

In the first and second embodiments described above, the irradiated ion guide member 50 is formed into a substantially tubular shape. However, the irradiated ion guide member may be formed into the other shapes, a hollow square columnar shape or a ring shape.

## Claims

1. A deposition apparatus, comprising:
a vacuum chamber grounded on the earth;
a substrate holder supported in the vacuum chamber;
a substrate capable of being held by the substrate holder;
a deposition means placed distant from the substrate by a predetermined distance so as to face the substrate;
an ion gun for irradiating ions to the substrate; and
a neutralizer for irradiating electrons to the substrate, wherein
the neutralizer is arranged so that an electron irradiation port is placed in the direction of the substrate,
the ion gun is arranged on an opposite side to a side where the substrate holder is arranged inside the vacuum chamber so that an ion irradiation port faces the substrate,
an irradiated ion guide member for regulating an irradiation range of the ions is arranged between the ion irradiation port of the ion gun and the substrate holder so as to reduce a diffusion range of the ions irradiated from the ion irradiation port, and
the irradiated ion guide member is electrically floating with respect to the vacuum chamber.

2. The deposition apparatus according to claim 1, wherein
an irradiated electron guide member for regulating an irradiation range of the electrons is arranged between the electron irradiation port of the neutralizer and the substrate holder so as to reduce a diffusion range of the electrons irradiated from the electron irradiation port, and
the irradiated electron guide member is electrically floating with respect to the vacuum chamber.

3. The deposition apparatus according to claim 1, wherein
an irradiated electron guide member for regulating an irradiation range of the electrons is arranged between the electron irradiation port of the neutralizer and the substrate holder so as to reduce a diffusion range of the electrons irradiated from the electron irradiation port,
the irradiated electron guide member is electrically floating with respect to the vacuum chamber, and
at least one of the irradiated ion guide member and the irradiated electron guide member is formed into a tubular shape, and arranged so that the ions irradiated from the ion gun or the electrons irradiated from the neutralizer are capable of passing through the inside of a tubular part.

4. The deposition apparatus according to claim 1, wherein
the irradiated ion guide member is formed into a plate shape and arranged at a position where shield part of the ions irradiated from the ion gun is shielded.

5. The deposition apparatus according to claim 1, wherein
an irradiated electron guide member for regulating an irradiation range of the electrons is arranged between the electron irradiation port of the neutralizer and the substrate holder so as to reduce a diffusion range of the electrons irradiated from the electron irradiation port,
the irradiated electron guide member is electrically floating with respect to the vacuum chamber,
at least one of the irradiated ion guide member and the irradiated electron guide member has a double structure including an inner member and an outer member, and
the inner member and the outer member are provided side by side so as to have a gap therebetween and electrically floating from each other.

6. The deposition apparatus according to claim 1, wherein
the vacuum chamber is provided with an inner wall electrically floating with respect to the vacuum chamber.

7. The deposition apparatus according to claim 1, wherein
the neutralizer is arranged at a position distant from the ion gun.

8. A manufacturing method of a thin film device using a deposition apparatus comprising:
a vacuum chamber grounded on the earth;
a substrate holder supported in the vacuum chamber;
a substrate capable of being held by the substrate holder;
a deposition means placed distant from the substrate by a predetermined distance so as to face the substrate;
an ion gun arranged on an opposite side to a side where the substrate holder is arranged inside the vacuum chamber so that an ion irradiation port faces the substrate, the ion gun for irradiating ions to the substrate;
a neutralizer arranged on a side surface side of the vacuum chamber, the neutralizer for irradiating electrons to the substrate;
a shutter respectively arranged in an immediate vicinity of a deposition material irradiation port of the deposition means and the ion irradiation port of the ion gun;
an irradiated ion guide member arranged between the ion irradiation port of the ion gun and the substrate holder so as to reduce a diffusion range of the ions irradiated from the ion irradiation port; and
an irradiated electron guide member arranged between the electron irradiation port of the neutralizer and the substrate holder so as to reduce a diffusion range of the electrons irradiated from the electron irradiation port,
the manufacturing method, comprising:
an arrangement step of arranging the substrate in the substrate holder;
a setting step of rotating the substrate holder by a predetermined rotation number, setting pressure in the vacuum chamber to a predetermined value, and increasing a temperature of the substrate to a predetermined value;
a preparation step of bringing the ion gun and the deposition means to an idling state; and
a deposition step of irradiating the deposition material to the substrate by opening the shutter, wherein
in the deposition step, the ions are irradiated from the ion gun toward the substrate through the irradiated ion guide member, and at the same time, the electrons are irradiated from the neutralizer arranged close to the substrate holder so as to be distant from the ion gun by a predetermined distance toward the substrate through the irradiated electron guide member.
